# EUROPEAN PATENT APPLICATION

(11) **EP 1 174 400 A1**
(43) Date of publication of application: **23.01.2002**
(21) Application number: 00977905.9
(22) Date of filing: 24.11.2000
(51) Int. Cl.: C04B 38/00, C04B 41/88, C04B 35/565, H01L 21/304

(54) **POROUS SILICON CARBIDE SINTERED COMPACT AND SILICON CARBIDE METAL COMPOSITE SUITABLE FOR USE IN TABLE FOR WAFER POLISHING MACHINE**

(30) Priority: 30.11.1999 JP 34040899; 30.11.1999 JP 34040999; 26.04.2000 JP 2000126085
(71) Applicant: IBIDEN CO., LTD., Ogaki-shi Gifu-ken 503-8604 (JP)
(72) Inventor: MAJIMA, Kazutaka, Ibiden Co. Ltd. Ogaki-Kita Plant, Ibi-gun, Gifu 501-0695 (JP); YASUDA, Hiroyuki, Ibiden Co. Ltd. Ogaki-Kita Plant, Ibi-gun, Gifu 501-0695 (JP)
(74) Representative: Banzer, Hans-Jörg, Dipl.-Ing.
(86) International application number: JP0008284
(87) International publication number: WO0140138

(57) **Abstract**

A porous silicon carbide sinter having superior thermal uniformity, thermal response, and shape stability. The porous sinter is formed by silicon carbide crystals (21, 22), and the structure formed by the silicon carbide crystals includes opened pores (23). The silicon carbide crystals have an average grain diameter of 20µm or greater, a porosity of 40% or less, and a thermal conductivity of 80W/m·K or more.

## Description

### TECHNICAL AREA

The present invention relates to a porous silicon carbide sinter and a silicon carbide-metal composite, and more particularly, to a silicon carbide sinter and a silicon carbide-metal composite that are optimal for a table that is used by an apparatus for grinding semiconductor wafers, and to a method for manufacturing a silicon carbide sinter and a silicon carbide-metal composite.

### BACKGROUND ART

Many present-day electric products use semiconductor devices that are manufactured by forming microscopic semiconducting circuits on silicon chips. Such a semiconductor device is manufactured from a monocrystal silicon ingot through the procedure described below.

The monocrystal silicon ingot is first sliced into thin pieces. The sliced pieces are ground in a lapping process and a polishing process. A bare wafer that has undergone these processes has a mirror surface and is thus referred to as a mirror wafer. Further, a bare wafer that has undergone an epitaxial layer forming process subsequent to the lapping process and prior to the polishing process is specifically referred to as an epitaxial wafer.

In a following wafer treating process, the bare wafer repetitively undergoes oxidation, etching, and impurity dispersion. After undergoing the above processes, the bare wafer undergoes a dicing process and is cut to an appropriate size thereby finally completing the desired semiconductor device.

In the above processes, the surface of the semiconductor wafer on which a device is formed must be ground in one way or another. Accordingly, various wafer grinders (lapping machines and polishing machines) have been proposed in the prior art as effective means for performing such grinding.

A typical wafer grinder includes a table, a pusher plate, and a cooling jacket. The table is fixed to an upper portion of the cooling jacket. The table and the cooling jacket are both made of a metal material such as stainless steel. The cooling jacket includes a flow passage through which cooling water circulates to cool the table. A wafer that is to be ground is adhered to a holding surface (lower surface) of the pusher plate, which is arranged above the table, by a thermoplastic wax. The wafer held by the pusher plate, which is rotated, is pressed against a grinding surface (top surface) of the table from above the table. As a result, the wafer contacts the grinding surface and the surface on one side of the wafer is uniformly ground. The heat that is built up in the wafer in this state is transferred to the cooling jacket via the table and released from the grinder by the cooling water circulating through the flow passage in the cooling jacket.

The wafer grinder table is often heated to a high temperature during a grinding operation. It is thus required that the table be formed from a material that is heat resistant and thermal impact resistant. Further, frictional force is constantly applied to the grinding surface of the table. Thus, it is also required that the table be formed from a material that is abrasion resistant. Additionally, the generation of thermal stress, which bends the wafer, must be avoided to manufacture a wafer having a large diameter and high quality. Thus, the temperature difference within the table must be minimal. It is thus required that the material also have high thermal conductance.

Due to the above circumstances, there are some ceramic materials having superior physical and mechanical properties (i.e., new ceramic and engineering ceramic) that are recently drawing attention as materials that will take place of the metal material that has been used to form the table. Among these materials, silicon carbide (SiC) has been receiving particular attention.

Silicon carbide has optimal characteristics such as superior thermal conductance, heat resistance, thermal impact resistance, abrasion resistance, hardness, oxidation resistance, and corrosion resistance. Thus, silicon carbide may be used as, for example, an abrasion resistant material used in mechanical seals, bearings, or the like, a thermal resistant structural material used in a fireproof element of a high temperature furnace, a heat exchanger, a combustion pipe, or the like, or a corrosion resistant material used in pump components or the like, which tend to be exposed to acids and alkalis. The characteristics of silicon carbide, especially, high thermal conductance, have resulted in a recent proposal to use silicon carbide in the table. Additionally, the impregnation of metal in opened pores of a porous silicon carbide body to produce a silicon carbide-metal composite having thermal conductance that is superior to a non-impregnated body has been proposed.

A silicon carbide sinter has an advantage in that temperature differences do not occur in the sinter due to its ability to efficiently transfer heat. Accordingly, the sinter has high thermal uniformity and thermal response. Further, since thermal stress is not produced and base materials resist bending, the shape stability increases.

However, although the thermal conductivity of the silicon carbide sinter is higher than other ceramic sinters, the value of thermal conductivity of a porous body is only about 10W/m·K to 70W/m·K. Further, although the thermal conductivity of the silicon carbide-metal composite is higher than a silicon carbide non-impregnated body, the value of thermal conductivity is presently only about 100W/m·K to 150W/m·K.

Accordingly, the heat conductivity must be further increased to produce a superior material having further thermal uniformity, thermal response, and shape stability. Further, if the material is used in the table, the thermal conductance must be further increased in the same manner to manufacture wafers having larger diameters and higher quality.

When superimposing sheets of base materials, which are made of silicon carbide-metal composite, and bonding the base materials with a resin adhesive, a table having a flow passage in the bonding interface has the shortcomings described below.

In the prior art, an adhesive, the thermal conductivity of which is low, is used to bond base materials. Thus, the adhesive increases the thermal resistance in the bonding interface and decreases the thermal conductivity of the table as a whole. Accordingly, the actual thermal uniformity and thermal response are insufficient regardless of the employment of the silicon carbide-metal composite that has high thermal conductivity. Further, the coefficients of thermal expansion differ significantly between the silicon carbide-metal composite and the adhesive. Thus, cracking and exfoliation are apt to occur at the bonding interface. Accordingly, the table was vulnerable to damage when subjected to a heat cycle, and the long-term reliability was low. Further, when using a brazing material in lieu of the adhesive to bond base materials, the problem of the increased thermal resistance may be solved. However, cracking and exfoliation, which result from the difference in the coefficients of thermal expansion, cannot be prevented.

### DISCLOSURE OF THE INVENTION

It is a first object of the present invention to provide a porous silicon carbide body, and a silicon carbide-metal composite having superior thermal conductivity, thermal response, and shape stability.

It is a second object of the present invention to provide a method that ensures the manufacturing of such optimal sinter and composite.

It is a third object of the present invention to provide a wafer grinder member and a wafer grinder table that is optimal for manufacturing large diameter, high quality wafers.

A first aspect of the present invention is a porous sinter having a structure formed by silicon carbide crystals that includes opened pores. The porous silicon carbide sinter has a silicon carbide crystal average grain diameter of 20 µm or greater, a porosity of 40% or less, and a thermal conductivity of 80W/m·K or more.

A second aspect of the present invention is a porous sinter having a structure formed by silicon carbide crystals that includes opened pores. The porous silicon carbide sinter has a silicon carbide crystal average grain diameter of 20µm to 100µm, a porosity of 5% to 30%, and a thermal conductivity of 80W/m·K or more.

A third aspect of the present invention is a method for manufacturing a porous silicon carbide sinter having a structure formed by silicon carbide crystals that includes opened pores. The porous silicon carbide sinter has a silicon carbide crystal average grain diameter of 20µm or greater, a porosity of 30% or less, and a thermal conductivity of 80W/m·K or more. The method includes adding 10 parts by weight to 100 parts by weight of a fine powder of α silicon carbide having an average grain diameter of 0.1µm to 1.0µm to 100 parts by weight of a rough powder of α silicon carbide having an average grain diameter of 5µm to 100µm and uniformly mixing the rough powder and the fine powder. A molded product is produced by molding a mixture obtained in the mixing step into a predetermined shape. The molded product is sintered within a temperature range of 1700°C to 2400°C to produce a sinter.

A fourth aspect of the present invention is a table having a grinding surface for grinding a semiconductor wafer held on a wafer holding plate. The table includes a plurality of bonded base materials, each formed from a porous silicon carbide sinter, and a fluid passage formed in a bonding interface of the base materials.

A fifth aspect of the present invention is a silicon carbide-metal composite having a porous structure formed by silicon carbide crystals that includes opened pores. The opened pores are impregnated with metal. The silicon carbide-metal composite has a silicon carbide crystal average grain diameter of 20µm or greater, a porosity of 30% or less, and a thermal conductivity of 160W/m·K or more. Further, 100 parts by weight of silicon carbide are impregnated with 15 parts by weight to 50 parts by weight of metal.

A sixth aspect of the present invention is a silicon carbide-metal composite having a porous structure formed by silicon carbide crystals that includes opened pores. The opened pores are impregnated with metal. The silicon carbide-metal composite has a silicon carbide crystal average grain diameter of 20µm to 100µm, a porosity of 5% to 30%, and a thermal conductivity of 160W/m·K or more. Further, 100 parts by weight of silicon carbide are impregnated with 15 parts by weight to 50 parts by weight of metal.

A seventh aspect of the present invention is a method for manufacturing a silicon carbide-metal composite having a porous structure formed by silicon carbide crystals that includes opened pores. 100 parts by weight of silicon carbide are impregnated with 15 parts by weight to 50 parts by weight of metal in the opened pores. The average grain diameter of the silicon carbide crystals is 20µm or greater, the porosity is 30% or less, and the thermal conductivity is 160W/m·K or more. The method includes adding 10 parts by weight to 100 parts by weight of a fine powder of α silicon carbide having an average grain diameter of 0.1µm to 1.0µm to 100 parts by weight of a rough powder of α silicon carbide having an average grain diameter of 5µm to 100µm and uniformly mixing the rough powder and the fine powder. A mixture is produced in the mixing step into a predetermined shape to produce a molded product. The molded product is sintered within a temperature range of 1700°C to 2400°C to produce a sinter. The molded product or the sinter is impregnated with metal.

An eighth aspect of the present invention is a table having a grinding surface for grinding a semiconductor wafer held on a wafer holding plate. The table includes a plurality of bonded base materials, each formed from the silicon carbide-metal, and a fluid passage formed in a bonding interface of the base materials.

A ninth aspect of the present invention is a table having a grinding surface for grinding a semiconductor wafer held on a wafer holding plate. The table includes a plurality of base materials, each of which is a ceramic-metal composite formed by impregnating metal silicon in opened bores of a porous body made of silicon-containing ceramic. A bonding layer is formed from the metal silicon to bond the base materials, and a fluid passage is formed in a bonding interface of the base materials.

### BRIEF DESCRIPTION OF THE DRAWINGS

Fig. 1 is a schematic view showing a wafer grinder according to a first embodiment of the present invention.
Fig. 2 is an enlarged cross-sectional view showing the main portion of a table used in the wafer grinder of Fig. 1.
Fig. 3 is an enlarged schematic cross-sectional view of the table of Fig. 2.
Figs. 4A, 4B, and 4C are graphs showing the grit distribution of porous silicon carbide sinters that form the table of Fig. 2.
Fig. 5 is an enlarged schematic cross-sectional view showing a table according to a second embodiment of the present invention.
Fig. 6A is an enlarged cross-sectional view showing the main portion of a table according to a third embodiment of the present invention, and Fig. 6B is an enlarged schematic cross-sectional view showing the table of Fig. 6A.
Figs. 7A, 7B, and 7C are schematic cross-sectional views illustrating a process for manufacturing the table of Fig. 6A.

### BEST MODE FOR CARRYING OUT THE INVENTION

### (First Embodiment)

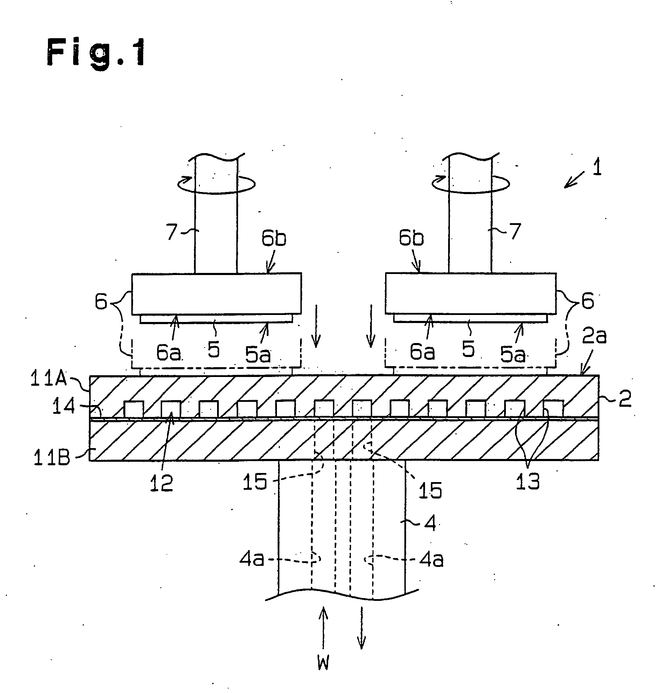

A wafer grinder 1 according to a first embodiment will now be discussed with reference to Figs. 1 to 4.

Fig. 1 schematically shows the wafer grinder 1 of the present embodiment. A table 2, which forms the wafer grinder 1, is disk-like. A grinding surface 2a for grinding a semiconductor wafer 5 is defined on the top surface of the table 2. A grinding cloth (not shown) is adhered to the grinding surface 2a. The table 2 of the present embodiment does not use a cooling jacket and is horizontally and directly fixed to the upper end surface of a cylindrical rotary shaft 4. Accordingly, rotation of the rotary shaft 4 rotates the table 2 integrally with the rotary shaft 4.

As shown in Fig. 1, the wafer grinder 1 includes a plurality of wafer holding plates 6 (two shown in Fig. 1 to facilitate illustration). The plates 6 may be formed from, for example, a ceramic material, such as glass or alumina, or a metal material, such as stainless. A pusher rod 7 is fixed to the center of one side (non-holding surface 6b) of each wafer holding plate. Each pusher rod 7 is located above the table 2 and connected to a driving means (not shown). Further, each pusher rod 7 horizontally supports the wafer holding plate 6. In this state, the holding surface 6a is opposed to the grinding surface 2a of the table 2. In addition to rotating integrally with the wafer holding plate 6, each pusher rod 7 moves vertically within a predetermined range. Instead of moving the plate 6 vertically, a structure that moves the table 2 vertically may be employed. A semiconductor wafer 5 is adhered to the holding surface 6a of the wafer holding plate 6 by, for example, an adhesive such as thermoplastic wax. The semiconductor wafer 5 may be attracted to the holding surface 6a by vacuum suction or static electricity. In this state, it is required that a ground surface 5a of the semiconductor wafer 5 face the grinding surface 2a of the table 2.

The structure of the table 2 will now be discussed in detail.

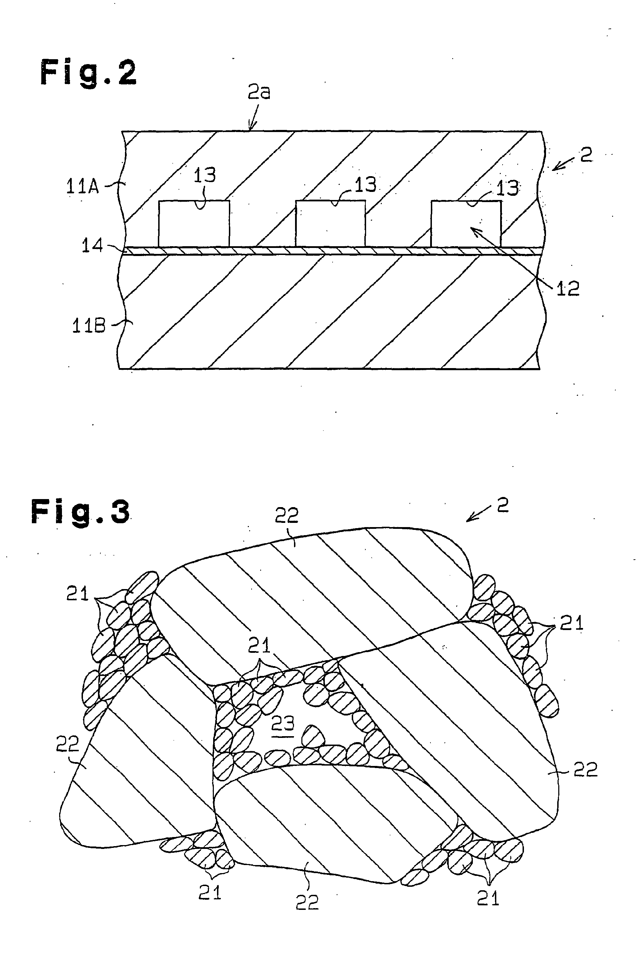

As shown in Figs. 1 and 2, the table 2 of the present embodiment is a superimposed ceramic structure formed by two base materials 11A, 11B, which are made of porous silicon carbide sinter. Grooves 13 arranged in a predetermined pattern and defining part of a coolant passage 12, which is a fluid passage, are formed in the lower surface of the upper base material 11A. The two base materials 11A, 11B are integrally connected to each other by a silver brazing material layer 14. This forms the coolant passage 12 in the bonding interface of the base materials 11A, 11B. Bores 15 are formed in the central portion of the lower substrate 11B. The bores 15 connect flow passages 4a, which extend through the rotary shaft 4, to the coolant passage 12.

The grooves 13, which form part of the coolant passage 12, are ground grooves that are formed by roughly machining the rear surface of the upper base material 11A and then grinding the rear surface before undergoing sintering. It is preferred that the grooves 13 have a depth of about 3mm to 10mm and a width of about 5mm to 20mm.

In the present embodiment, the average grain diameter of the silicon carbide crystals forming a porous structure is set at a relatively large value of 20µm or greater. The efficiency of heat transfer within crystals is generally higher than the efficiency of heat transfer between crystals. Thus, the thermal conductivity increases as the average grain diameter increases. Further, the porosity is set at a small value of 40% or less. This also contributes to increasing the thermal conductivity. In other words, the gaps in a sinter decrease as the porosity decreases. This facilitates the transfer of heat.

Therefore, the temperature difference in the sinter becomes less in comparison to the conventional porous body, the thermal conductivity of which is much smaller than 80W/m·K. As a result, the sinter has significantly high thermal uniformity and thermal response. Further, since the production of thermal stress is avoided and the base materials resist bending, the sinter has extremely high shape stability.

In this case, if the average grain diameter of the silicon carbide crystal is less than 20µm or if the porosity exceeds 30%, it is difficult for the thermal conductivity to be a value that is 80W/m·K or higher. Accordingly, the thermal uniformity, thermal response, and shape stability cannot be sufficiently improved. It is required that the value of thermal conductivity be 80W/m·K or greater, preferably 100W/m or more, and most preferably 100W/m·K to 180W/m·K.

It is preferred that the average grain diameter of the silicon carbide crystals be 20µm to 100µm, more preferred that the average grain diameter be 30µm to 90µm, and most preferred that the average grain diameter be 40µm to 10µm. When the average grain diameter becomes excessively large, the gaps increase and may decrease the density of the sinter.

It is preferred that the opened pore porosity be 5% to 30%, more preferred that the porosity be 10% to 25%, and most preferred that the porosity be 10% to 20%.

Further, it is preferred that the sinter includes 10vol/% to 50vol% of fine silicon carbide crystals (hereafter referred to as fine crystals 21) having an average grain diameter of 0.1µm to 1.0µm and 50vol% to 90vol% of rough silicon carbide crystals (hereafter referred to as rough crystals 22) having an average grain diameter of 25µm to 65µm.

When the fine crystals 21 and the rough crystals 22 are included in the sinter at an appropriate ratio as described above, the gaps formed between the rough crystals 22 tend to be filled with the fine crystals 21. This decreases the actual ratio of the gaps. As a result, the thermal resistance of the sinter is further decreased. This significantly contributes to improving the thermal conductance.

It is preferred that the average grain diameter of the fine crystals 21 be 0.1µm to 1.0µm, more preferred that the average grain diameter be 0.1µm to 0.9µm, and most preferred that the average grain diameter be 0.1µm to 0.7µm. To make the average grain diameter of the fine crystals 21 extremely small, expensive fine powder must be used. This may increase the material cost. On the other hand, if the average grain diameter of the fine particles 21 becomes too large, the gaps formed between rough crystals 22 cannot by sufficiently filled. The decrease in the thermal resistance of the sinter may thus be insufficient.

It is preferred that the sinter include 10vol/% to 50vol% of the fine crystals 21, more preferred that the sinter include 15vol% to 40vol% of the fine crystals 21, and most preferred that the sinter include 20vol% to 40vol% of the fine crystals 21. If the content ratio of the fine crystals 21 is too small, the amount of the fine crystals 21 that fill the space formed between the rough crystals 22 is insufficient. The thermal resistance of the sinter may thus not be decreased. On the other hand, if the content ratio of the fine crystals 21 is too large, the fine crystals 21 that fill the gaps is excessive and the amount of rough crystals 22 that is required to improve the thermal conductance is insufficient. This may increases the thermal conductance of the sinter.

Further, it is preferred that the average grain diameter of the rough crystals 22 in the sinter be 25µm to 150µm, more preferred that the average grain diameter be 40µm to 100µm, and most preferred that the average grain diameter be 60µm to 100µm. When the average grain diameter of the rough crystal 22 is extremely small, the difference between the grain diameters of the rough crystals 22 and the fine crystals 21 is small. As a result, the desired thermal resistance decreasing effect may not be obtained from the mixture of the fine crystals 21 and the rough crystals 22. On the other hand, if the average grain diameter of the rough crystals 22 is too large, the gaps formed between the rough crystals are large. Thus, even if the amount of fine crystals 21 is sufficient, the gaps may not be sufficiently filled. Accordingly, the decrease in the thermal resistance of the sinter may be insufficient.

It is preferred that the sinter includes 50vol/% to 90vol% of the rough crystals 22, more preferred that the sinter includes 60vol% to 85vol% of the rough crystals 22, and most preferred that the sinter includes 60vol% to 80vol% of the rough crystals 22. If the content ratio of the rough crystals 22 is too small, the amount of the rough crystals 22 required to increase the thermal conductivity is too small. This may increase the thermal resistance of the sinter. On the other hand, if the content ratio of the rough crystals 22 is too large, the content ration 21 of the fine crystals 21 relatively decreases. Thus, the gaps formed between the rough crystals 22 cannot be filled. Accordingly, the decrease in the thermal resistance of the sinter may be insufficient.

A method for manufacturing the porous silicon carbide sinter, which forms the table 2, will now be discussed.

The porous silicon carbide sinter is manufactured through a material preparing process, in which fine powder is mixed with rough powder at a predetermined ratio, a molding process, and a sintering process.

In the material preparing process, 10 parts by weight to 100 parts by weight of a fine powder of α silicon carbide having an average grain diameter of 0.1 µm to 1.0µm is uniformly mixed with 100 parts by weight of a rough powder of α silicon carbide having an average grain diameter of 5µm to 100µm.

It is preferred that the average grain diameter of the rough powder of α silicon carbide be 5µm to 100µm, more preferred that the average grain diameter be 15µm to 75µm, and most preferred that the average grain diameter be 25µm to 60µm. If the average grain diameter of the α silicon carbide is less than 5µm, abnormal grain growth may not be effectively suppressed. On the other hand, if the average grain diameter of the rough powder of α silicon carbide exceeds 60µm, in addition to decreased moldability, the strength of the obtained porous decreases.

It is preferred that the average grain diameter of the fine powder of α silicon carbide be 0.1µm to 1.0µm, more preferred that the average grain diameter be 0.1µm to 0.8µm, and most preferred that the average grain diameter be 0.2µm to 0.5µm. If the average grain diameter of the α silicon carbide is less than 0.1µm, it becomes difficult to control grain growth and material costs inevitably becomes high. On the other hand, if the average grain diameter of the α silicon carbide exceeds 1.0µm, it may become difficult to fill the gaps formed between the rough crystals 22. The alpha type is selected as the fine powder because, compared with the beta type, the crystal orientation is improved and the thermal conductivity is increased.

It is preferred that the mixed amount of the fine powder be 10 parts by weight to 100 parts by weight, more preferred that the mixed amount be 15 parts by weight to 65 parts by weight, and most preferred that the mixed amount be 20 parts by weight to 60 parts by weight. If the mixed amount of the fine powder is too small, the amount of fine crystals 21 that fill the space formed between the rough crystals 22 is insufficient. Thus, the decrease of the thermal resistance of the sinter may be insufficient. Further, this results in the necessity to set the sintering temperature at an extremely high temperature to obtain the desired pore diameter of 20µm or larger and is disadvantageous from the viewpoint of cost. On the other hand, if the mixed amount of the fine powder is too large, the amount of the rough crystals 22 required to improve thermal conductance is insufficient. Thus, the decrease of the thermal resistance of the sinter may be insufficient. Further, it becomes difficult to manufacture a sinter that has superior strength.

In the material preparing process, a molding binder and a dispersing solvent are mixed with the two types of powder as required. These substances are mixed and kneaded uniformly and the viscosity is adjusted as required to produce raw slurry. The raw slurry may be mixed by means of a vibrating mill, an attriter, a ball mill, a colloid mill, a high speed mixer, or the like. The mixed raw slurry may be kneaded by means of a, for example, a kneader.

Polyvinyl alcohol, methyl cellulose, carboxymethyl cellulose, hydroxyethyl cellulose, polyethylene glycol, phenol resin, epoxy resin, acrylic resin, or the like may be used as the molding binder. It is preferred that the content ratio of the molding binder normally be within the range of 1 part by weight to 10 parts by weight with respect to a total of 100 parts by weight of the silicon carbide powder. If the ratio is less than 1 part by weight, the strength of the manufactured molding product is insufficient, which makes handling difficult. On the other hand, if the ratio exceeds 10 parts by weight, cracks may be produced in the molded product when eliminating the molding binder through dehydration or the like. This would decrease yield.

An organic solvent, such as benzene or cyclohexene, an alcohol, such as methanol, and water, or the like may be used as the dispersing solvent.

Then, the raw slurry is used to form granules of silicon carbide. To granulate the silicon carbide powder, a commonly used technique that is known in the art, such as a mist-dry granulation process (the so-called spray-dry process), may be employed. In other words, a process that aerifies and quickly dries the raw slurry, which is accommodated in a container in a hot state, may be employed.

It is preferred that the granule moisture rate be 0.1wt% to 2.0wt% and further preferred that the granule moisture rate be 0.2wt% to 1.0wt%. This is because the thermal conductivity increases since the molding product density and the sinter density increase when the granule moisture rate is in the above range. If the granule moisture rate is less than 0.1wt%, the molding product density and the sinter density do not increase sufficiently. Thus, it becomes difficult for the thermal conductivity to increase. On the other hand, if the granule moisture rate exceeds 2.0wt%, the molding product may crack during dehydration. This would decrease yield.

In the following molding process, the granules, which are formed from the mixture obtained in the material preparing process, are molded into a predetermined shape to produce a molded product.

In this state, it is preferred that the molding pressure be 1.0t/cm² to 1.5t/cm², and more preferred that the molding pressure be 1.1t/cm² to 1.4t/cm². This is because the thermal conductivity increases since the molding product groove and sinter density increases. If the molding pressure is less than 1.0t/cm² to 1.5t/cm², the molding product density and the sinter density do not increase sufficiently. Thus, it becomes difficult for the thermal conductivity to increase. On the other hand, if molding is performed by applying a pressure that is greater than 1.5t/cm², the molding product density, or the like, may be sufficiently increased. However, an exclusive press would be necessary thus increasing equipment costs and complicating manufacturing.

It is preferred that the density of the molding product be 2.0g/cm³ or more, and especially preferred that the density be 2.2g/cm³ to 2.7g/cm³. This is because the number of locations where the silicon carbide grains are connected to one another is too small when the density of the molded product is too small. As a result, the strength of the manufactured porous body decreases and makes it difficult to handle. On the other hand, if the density of the molded product is increased, an exclusive press becomes necessary thus increasing equipment costs and complicating manufacturing.

In the following sintering process, the sinter is formed by sintering the molded body obtained in the molding process in a temperature range of 1700°C to 2400°C, preferably in the temperature range of 2000°C to 2300°C, and most preferably in the temperature range of 2000°C to 2300°C.

If the sintering temperature is too low, it is difficult for necks, which bond silicon carbide grains to one another, to grow sufficiently. Thus, high thermal conductivity and high strength may not be obtained. On the other hand, if the sintering temperature is too high, thermal decomposition of the silicon carbide occurs and decreases the strength of the sinter. In addition, the amount of thermal energy used by a sintering furnace increases. This is disadvantageous from the viewpoint of costs.

The interior of the sintering furnace during sintering should be maintained in a gas atmosphere (i.e., non-oxidation atmosphere, inert atmosphere) that contains at least one selected from, for example, argon, helium, neon, nitrogen, hydrogen, and carbon monoxide. The interior of the sintering surface may also be in a vacuum state.

It is advantageous that volatilization of the silicon carbide from the molded product be suppressed to improve the growth of the necks during sintering. Volatilization of the silicon carbide from the molded product is effectively suppressed by putting the molded body in an insulative container that can be sealed from ambient air. Graphite or silicon carbide are the preferred material for forming the insulative container.

By performing each of the above steps, the manufacturing of a porous silicon carbide sinter having superior thermal conductivity, thermal response, and shape stability is guaranteed.

Referential examples specifically employing the present embodiment will now be discussed.

### [Referential Example 1-1]

In referential example 1-1, a rough powder (#400) of α silicon carbide having an average grain diameter of 30µm and a fine powder (GMF-15H2) of α silicon carbide having an average grain diameter of 0.3µm were prepared. Then, 30 parts by weight of the fine powder was added to 100 parts by weight of the rough powder and uniformly mixed.

Then, 5 parts by weight of polyvinyl alcohol and 50 parts by weight of water were added to 100 parts by weight of the mixture and mixed in a ball mill for five hours to obtain a uniform mixture. After drying the mixture for a predetermined time to eliminate a certain amount of moisture, an appropriate amount of the dried mixture was granulated. In this state, the moisture rate of the granules was adjusted to about 0.8wt%. Subsequently, the granules of the mixture were molded by a metal mold by applying a pressure of 1.3t/cm². The disk-like molded product (50mmΦ, 5mmt) had a density of 2.6g/cm³.

Then, the lower surface of the molded product, which was subsequently formed into the upper base material 11A, was ground to form the grooves 13, which have a depth of 5mm and a width of 10mm, on the entire lower surface.

The molded product was then put into a crucible and sintered with a Tammann sintering furnace. The sintering was performed in an argon gas atmosphere of one atmosphere. During the sintering, the temperature was raised to 2200°C at a temperature rising rate of 10°C/min and maintained at this temperature for four hours.

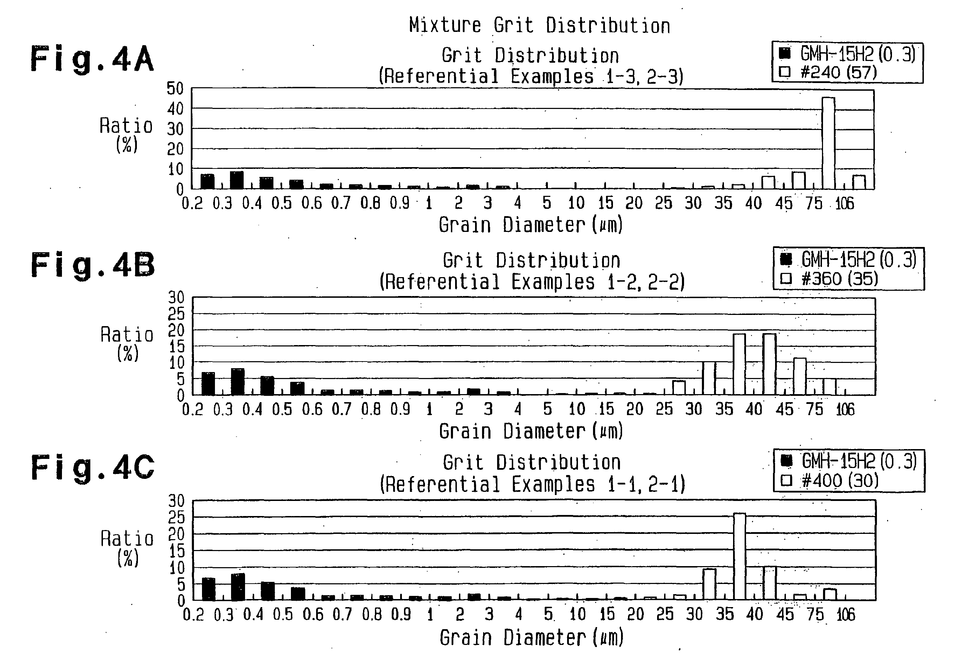

In the manufactured base materials 11A, 11B, which were made of porous silicon carbide sinter, the porosity of the opened pores 23 was 20%, the thermal conductivity was 130W/m·K, and the density was 2.5g/cm³. Further, the average grain diameter of the silicon carbide crystals was 30µm. More specifically, the base materials 11A, 11B included 20vol% of the fine crystals 21 having an average grain diameter of 1.0µm and 80vol% of the rough crystals'22 having an average grain diameter of 40µm. The graph of Fig. 4C shows the grit distribution of the sinter of referential example 1-1.

A shaping process was then performed using a technique known in the art. Afterward, the two base materials 11A, 11B were integrally bonded with each other using a silver brazing material. Further, the upper surface of the upper base material 11A was ground to complete the table 2.

The table 2 of the referential example 1-1 that was manufactured in this manner was set on various types of the grinder 1 and the semiconductor wafers 5 of varied sizes were ground while constantly circulating the cooling water W in the coolant passage 12. The semiconductor wafers 5, which were ground by the various types of the grinder 1, were observed. There was no damage to the wafers 5 regardless of size. Further, the wafers 5 were not bent. In other words, it was confirmed that the semiconductor wafers 5 having very large diameters and high quality were manufactured when using the table 2 of this referential example.

Fig. 3 is an enlarged schematic cross-sectional view showing the table 2 of referential example 1-1. The porous silicon carbide sinter forming the table 2 includes the fine crystals 21 and the rough crystals 22. The gaps formed between the rough crystals 22 are substantially filled with the fine crystals 21. Accordingly, it can be considered that the actual ratio of the gaps, or the porosity of the opened pores 23 is very small.

### [Referential Example 1-2]

In referential example 1-2, a rough powder (#360) of α silicon carbide having an average grain diameter of 35µm was used, and 30 parts by weight of fine powder was added to 100 parts by weight of rough powder and uniformly mixed. The other conditions were basically the same as referential example 1-1.

As a result, in the manufactured base materials 11A, 11B, which were made of porous silicon carbide sinter, the porosity of the opened pores 23 was 17%, the thermal conductivity was 145W/m·K, and the density was 2.55g/cm³. Further, the average grain diameter of the silicon carbide crystals was 35µm. More specifically, the base materials 11A, 11B included 20vol% of the fine crystals 21 having an average grain diameter of 1.0µm and 80vol% of the rough crystals 22 having an average grain diameter of 45µm. The graph of Fig. 4B shows the grit distribution of the sinter of referential example 1-2.

After completing the table 2 through the same procedure as referential example 1, the table 2 was set on the various types of the grinder 1 and the semiconductor wafers 5 of various sizes were ground. Like referential example 1-1, excellent results were obtained.

### [Referential Example 1-3]

In referential example 1-3, a rough powder (#240) of α silicon carbide having an average grain diameter of 57µm was used, and 30 parts by weight of fine powder was added to 100 parts by weight of the rough powder and uniformly mixed. The other conditions were basically the same as referential example 1-1.

As a result, in the manufactured base materials 11A, 11B, which were made of porous silicon carbide sinter, the porosity of the opened pores 23 was 15%, the thermal conductivity was 150W/m·K, and the density was 2.6g/cm³. Further, the average grain diameter of the silicon carbide crystals was 65µm. More specifically, the base materials 11A, 11B included 20vol% of the fine crystals 21 having an average grain diameter of 1.0µm and 80vol% of the rough crystals 22 having an average grain diameter of 80µm. The graph of Fig. 4A shows the grit distribution of the sinter of referential example 1-3.

After completing the table 2 through the same procedure as referential example 1, the table 2 was set on the various types of the grinder 1 and the semiconductor wafers 5 of various sizes were ground. Like referential example 1-1, excellent results were obtained.

### [Comparative Example 1]

In comparative example 1, a rough powder of α silicon carbide having an average grain diameter of 10µm was used, and 45 parts by weight of fine powder having an average grain diameter of 0.7µm was added to 100 parts by weight of the rough powder and uniformly mixed. The other conditions were basically the same as those of referential example 1-1.

Then, 5 parts by weight of polyvinyl alcohol and 50 parts by weight of water was added to 100 parts by weight of the mixture and mixed in a ball mill for five hours to obtain a uniform mixture. After drying the mixture for a predetermined time to eliminate a certain amount of moisture, an appropriate amount of the dried mixture was granulated. Subsequently, the granules of the mixture were molded by a metal mold by applying a pressure of 0.6t/cm². The disk-like molded product had a density of 2.0g/cm³.

Then, the lower surface of the molded product, which was subsequently formed into the upper base material 11A, was ground to form the grooves 13, which have a depth of 5mm and a width of 10mm, on substantially the entire lower surface.

The molded product was then put into a graphite crucible that seals out ambient air and sintered in a Tammann sintering furnace. The sintering was performed in an argon gas atmosphere of one atmosphere. During the sintering, the temperature was raised to 1700°C at a temperature rising rate of 10°C/min and maintained at this temperature for four hours.

As a result, in the manufactured base materials 11A, 11B, which were made of porous silicon carbide sinter, the porosity of the opened pores 23 was 38%, the thermal conductivity was 50W/m·K, and the density was 2.0g/cm³. Further, the average grain diameter of the silicon carbide crystals was 10µm.

Each of the referential examples in the present embodiment has the advantages described below.
(1) In the porous silicon carbide sinter that forms the table 2 in each of the referential examples, the average grain diameter of the silicon carbide crystals is 20µm to 100µm, the porosity is 5% to 30%, and the thermal conductivity is 80W/m·K or greater. Further, each of the sinters include 10vol% to 50vol% of the fine crystals 21 having an average grain diameter of 0.1µm to 1.0µm and 50vol% to 90vol% of the rough crystals 22 having an average grain diameter of 25µm to 65µm.
   Thus, the value of the thermal conductivity exceeds 100W/m·K and the table 2 has very high thermal conductance. Thus, the temperature difference in the sinter is smaller than the conventional products. As a result, the sinter has very high thermal uniformity and thermal response. Further, the production of thermal stress is avoided and the base materials 11A, 11B resist bending. Thus, the shape stability of the sinter is extremely high. Further, this enables the wafers 5 to have larger diameters and high quality.
(2) In the table 2, the cooling water W flows through the coolant passage 12, which is arranged in the bonding interface of the base materials 11A, 11B. Thus, the heat produced when grinding the semiconductor wafers 5 is directly and efficiently released from the table 2. In addition, fine control of the temperature is enabled. Thus, compared with a conventional apparatus that arranges a cooling jacket on the table to perform indirect cooling, the temperature difference in the table 2 is very small and the thermal uniformity and thermal response are improved drastically. Thus, the wafers 5 do not affect the apparatus 1 in an undesirable manner and enlargement of the diameters of the wafers 5 is enabled. In addition, since the wafers 5 are ground with high accuracy, the quality of the wafers 5 is high.

The present embodiment may be modified as described below.

In addition to a metal bonding material such as a brazing material, the base materials 11A, 11B may be bonded with each other by a resin adhesive (e.g., epoxy resin).

The base materials 11A, 11B do not necessarily have to bond by the brazing material layer 14. For example, the base materials 11A, 11B may be fastened to each other by nuts and bolts.

In the present embodiment, the table 2 may have a three-layer structure instead of the two-layer structure. A table may also have a superimposed structure with four or more layers.

Instead of forming the grooves 13 only in the upper base material 11A, the grooves 13 may be formed only in the lower base material 11B. Alternatively, the grooves 13 may be formed in both base materials 11A, 11B.

When using the table 2 of the present embodiment, a liquid other than water may be circulated in the coolant passage 12. Further, a gas may also be circulated.

In addition to the table 2 of the wafer grinder, the porous silicon carbide sinter according to the present invention may be employed in a member other than the table (e.g., wafer top plate). Of course, the application of the present invention is not restricted to an element that forms a semiconductor manufacturing apparatus such as the wafer grinder table 2. For example, the sinter may be used in a heat radiating body of a substrate to which electronic components are connected. Further, the sinter may of course be used as an abrasion resistant material for mechanical seals, bearings, or the like, a fireproof material for high temperature furnaces, a heat resistant structural material for heat exchangers, combustions pipes, or the like, and a corrosion resistant material for pumps or the like.

### (Second Embodiment)

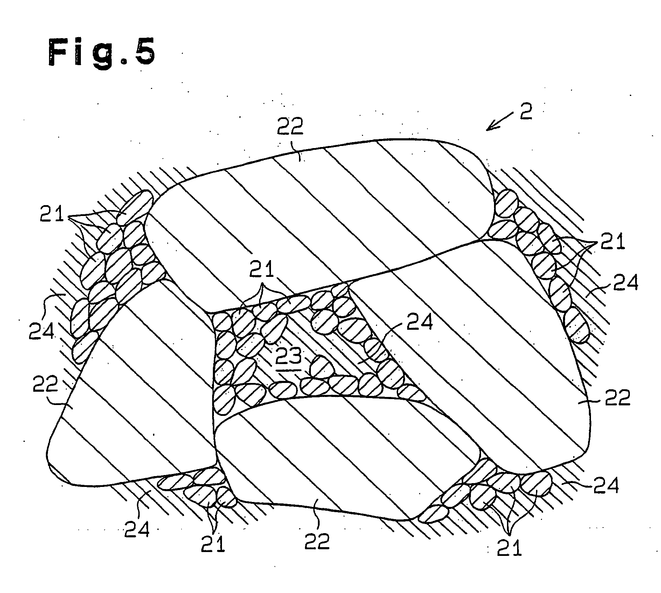

A table 2 according to a second embodiment will now be described with reference to Fig. 5. Parts that are the same as the first embodiment will not be described in detail.

In the silicon carbide-metal composite of the present embodiment, the average grain diameter of the silicon carbide crystals is 20µm or greater, the porosity is 30% or less, and the thermal conductivity is 160W/m·K or greater. Further, 100 parts by weight of silicon carbide is impregnated with 15 parts by weight to 50 parts by weight of metal.

The average grain diameter of the silicon carbide crystals forming the porous structure is a relatively large value that is 20µm or greater. The efficiency of heat transfer within crystals is generally higher than the efficiency of heat transfer between crystals. Thus, the thermal conductivity increases as the average grain diameter increases. Further, the porosity is set at a small value of 30% or less. This also contributes to increasing the thermal conductivity. In other words, the gaps in the porous structure decrease as the porosity decreases. This facilitates the transfer of heat. The impregnation of 100 parts by weight of silicon carbide with 15 parts by weight to 50 parts by weight of metal improves the thermal conductivity.

Further, in comparison to a conventional composite having thermal conductivity that is much lower than 160W/m·K, the temperature difference in the composite is small. As a result, the composite has high thermal uniformity and thermal response. Further, since thermal stress is not produced and the base materials 11A, 11B resist bending, the shape stability of the composite increases.

In this case, if the average grain diameter of the silicon carbide crystals is less than 20µm or the porosity exceeds 30%, it is difficult for the thermal conductivity to have a large value of 160W/m·K or greater even if impregnation is performed. Accordingly, the thermal uniformity, thermal response, and shape stability are not sufficiently improved. It is required that the value of thermal conductivity be 160W/m·K or greater, preferably 180W/m·K to 280W/m·K, and most preferably 200W/m·K to 260W/m·K.

In the present embodiment, it is required that 100 parts by weight of silicon carbide be impregnated with 15 parts by weight to 50 parts by weight of metal. By performing metal impregnation, the opened pores 23 in the sinter are filled with metal. This virtually forms a dense body and increases the thermal conductivity and strength.

It is preferred that metal silicon 24 be selected as the impregnation metal. The metal silicon 24 adapts well to silicon carbide and has a high thermal conductivity. Thus, 'by filling the opened pores in the sinter with the metal silicon 24, an improvement in the thermal conductance and strength is guaranteed.

In this case, it is preferred that 100 parts by weight of silicon carbide be impregnated with 15 to 45 parts by weight of the metal silicon 24, and further preferred that the silicon carbide be impregnated with 15 to 30 parts by weight of the metal silicon 24. If the impregnated amount is less than 15 parts by weight, the thermal resistance of the composite may not be decreased. On the other hand, if the impregnated amount exceeds 30 parts by weight, the proportion of the crystal may relatively decrease and, in some cases, decrease thermal conductivity.

When selecting a material other than metal silicon 24 such as metal aluminum, 100 parts by weight of silicon carbide may be impregnated with 20 to 50 parts by weight of the metal aluminum. If the impregnated amount is not included in the above range, the thermal conductivity may decrease.

A method for manufacturing the porous silicon carbide sinter, which forms the table 2, will now be discussed.

The porous silicon carbide sinter of this embodiment is manufactured through a material preparing process, in which fine powder is mixed with rough powder at a predetermined ratio, a molding process, a sintering process, and a metal impregnating process. The metal impregnating process may be performed either before or after the sintering process. The material preparing process, the molding process, and the sintering process have been described in the first embodiment and will thus not be discussed below.

In a metal impregnating process that is performed after the sintering process, metal is impregnated in the sinter (i.e., non-impregnated composite) as described below.

For example, when impregnating the metal silicon 24, it is preferred that the sinter be impregnated with a carbonaceous substance beforehand. Such a carbonaceous substance includes an organic substance, such as furfural resin, phenol resin, lignin sulfonic acid, polyvinyl alcohol, cornstarch, molasses, coal-tar pitch, and alginate. Pyrolitic carbon such as carbon black and acetylene may also be used.

A carbonaceous substance is impregnated beforehand because it forms a new silicon carbide film on the surface of the opened pores 23 of the sinter and strengthens the bonding between the molten silicon and the porous body. Further, the impregnation of the carbonaceous substance increases the strength of the sinter.

The metal silicon 24 may be filled in the opened pores 23, for example, by heating and melting the metal silicon 24 and impregnating the melted silicon. Further, fine grains of the metal silicon 24 may be dispersed in a dispersion liquid. Then, a porous body may be impregnated with the dispersion liquid and heated to a metal silicon melting temperature or higher.

The metal impregnating process may be performed on a molded product, or before the sintering process. This would save power and thus decrease cost although the quality of the obtained product would slightly deteriorate.

A few referential examples specifically employing the present embodiment will now be discussed.

### [Referential Example 2-1]

In referential example 2-1, a rough powder (#400) of α silicon carbide having an average grain diameter of 30µm and a fine powder (GMF-15H2) of α silicon carbide having an average grain diameter of 0.3µm were prepared. Then, 30 parts by weight of the fine powder was added to 100 parts by weight of the rough powder and uniformly mixed.

Then, 5 parts by weight of polyvinyl alcohol, 3 parts by weight of phenolic resin, and 50 parts by weight of water were added to 100 parts by weight of the mixture and mixed in a ball mill for five hours to obtain a uniform mixture. After drying the mixture for a predetermined time to eliminate a certain amount of moisture, an appropriate amount of the dried mixture was granulated. In this state, the moisture rate of the granules was adjusted to about 0.8wt%. Subsequently, the granules of the mixture were molded by a metal mold by applying a pressure of 1.3t/cm². The disk-like molded product (50mmΦ, 5mmt) had a density of 2.6g/cm³.

Then, the lower surface of the molded product, which was subsequently formed into the upper base material 11A, was ground to form the grooves 13, which have a depth of 5mm and a width of 10mm, on the entire lower surface.

The molded product was then put into a graphite crucible and sintered with a Tammann sintering furnace. The sintering was performed in an argon gas atmosphere of one atmosphere. During the sintering, the temperature was raised to 2200°C at a temperature rising rate of 10°C/min and maintained at this temperature for four hours.

The produced porous sinter was vacuum impregnated with phenolic resin (carbonization rate 30wt%) and then dried. Subsequently, the surface of the porous sinter was coated with slurry including the metal silicon 24. The mixture of 100 parts by weight of metal silicon powder, which had an average grain diameter of 20µm and a purity of 99.9999wt%, and 60 parts by weight of 5% acrylic acid ester benzene solution was used as the slurry. The porous sinter coated with metal silicon 24 was then heated in an argon gas current at a temperature rising rate of 450°C/hour and maintained at the maximum temperature of 1450°C for about one hour. This treatment impregnated the porous sinter with metal silicon and produced a silicon carbide-metal composite. The impregnation amount of the metal silicon 24 relative to 100 parts by weight of silicon carbide was 30 parts by weight.

In the manufactured base materials 11A, 11B, which were made of a silicon carbide-metal composite, the porosity of opened pores 23 in the porous structure was 20%, the thermal conductivity as a whole was 210W/m·K, and the density as a whole was 3.0g/cm³. Further, the average grain diameter of the silicon carbide crystals was 30µm. More specifically, the base materials 11A, 11B included 20vol% of the fine crystals 21 having an average grain diameter of 1.0µm and 80vol% of the rough crystals 22 having an average grain diameter of 40µm. The graph of Fig. 4C shows the grit distribution in referential example 2-1.

A shaping process was then performed using a technique known in the art. Afterward, the two base materials 11A, 11B were integrally bonded with each other using a silver brazing material. Further, the upper surface of the upper base material 11A was ground to complete the table 2.

The table 2 of the example 2-1 that was manufactured in this manner was set on various types of the grinder 1 and the semiconductor wafers 5 of varied sizes were ground while constantly circulating the cooling water W in the coolant passage 12. The semiconductor wafers 5, which were ground by the various types of the grinder 1, were observed. There were no damages to the wafers 5 regardless of size. Further, the wafers 5 were not bent. In other words, it was confirmed that the semiconductor wafers 5 having very large diameters and high quality were manufactured when using the table 2 of this referential example.

Fig. 5 is an enlarged schematic cross-sectional view showing the table 2 of referential example 2-1. The silicon carbide-metal composite forming the table 2 includes the fine crystals 21 and the rough crystals 22. The gaps formed between the rough crystals 22 are substantially filled with the fine crystals 21. Accordingly, it can be considered that the actual ratio of the gaps, or the porosity of the opened pores 23, is very small. In addition, the metal silicon 24 is embedded in the remaining gaps.

### [Referential Example 2-2]

In referential example 2-2, a rough powder (#360) of α silicon carbide having an average grain diameter of 35µm was used, and 40 parts by weight of fine powder was added to 100 parts by weight of the rough powder and uniformly mixed. The other conditions were basically the same as referential example 2-1.

As a result, in the manufactured base materials 11A, 11B, which were made of silicon carbide-metal composite, the porosity of the opened pores of the porous structure was 17%, the entire thermal conductivity was 220W/m·K, and the density was 3.0g/cm³. Further, the average grain diameter of the silicon carbide crystals was 36µm. More specifically, the base materials 11A, 11B included 20vol% of the fine crystals 21 having an average grain diameter of 1.0µm and 80vol% of the rough crystals 22 having an average grain diameter of 45µm. The graph of Fig. 4B shows the grit distribution of the sinter of referential example 2-2.

After completing the table 2 through the same procedure as referential example 2-1, the table 2 was set on the various types of the grinder 1 and the semiconductor wafers 5 of various sizes were ground. Like referential example 2-1, excellent results were obtained.

### [Referential Example 2-3]

In referential example 2-3, a rough powder (#240) of α silicon carbide having an average grain diameter of 57µm was used, and 40 parts by weight of fine powder was added to 100 parts by weight of the rough powder and uniformly mixed. The other conditions were basically the same as referential example 2-1.

As a result, in the manufactured base materials 11A, 11B, which were made of silicon carbide-metal composite, the porosity of the opened pores 23 was 15%, the thermal conductivity was 230W/m·K, and the density was 3.1g/cm³. Further, the average grain diameter of the silicon carbide crystals was 65µm. More specifically, the base materials 11A, 11B included 20vol% of the fine crystals 21 having an average grain diameter of 1.0µm and 80vol% of the rough crystals 22 having an average grain diameter of 80µm. The graph of Fig. 4A shows the grit distribution of the sinter of referential example 2-3.

After completing the table 2 through the same procedure as referential example 2-1, the table 2 was set on the various types of the grinder 1 and the semiconductor wafers 5 of various sizes were ground. Like referential example 2-1, excellent results were obtained.

### [Comparative Example 2]

In comparative example 2, a rough powder of α silicon carbide having an average grain diameter of 10µm was used, and 45 parts by weight of fine powder having an average grain diameter of 0.7µm was added to 100 parts by weight of the rough powder and uniformly mixed. The other conditions were basically the same as referential example 1-1.

Then, 5 parts by weight of polyvinyl alcohol and 50 parts by weight of water was added to 100 parts by weight of the mixture and mixed in a ball mill for five hours to obtain a uniform mixture. After drying the mixture for a predetermined time to eliminate a certain amount of moisture, an appropriate amount of the dried mixture was granulated. Subsequently, the granules of the mixture were molded by a metal mold by applying a pressure of 0.6t/cm². The disk-like molded product had a density of 2.0g/cm³. Then, the metal silicon 24 was impregnated under the same conditions as referential example 1-1.

Then, the lower surface of the molded product, which was subsequently formed into the upper base material 11A, was ground to form the grooves 13, which have a depth of 5mm and a width of 10mm, on substantially the entire lower surface.

The molded product was then put into a graphite crucible that seals out ambient air and sintered in a Tammann sintering furnace. The sintering was performed in an argon gas atmosphere of one atmosphere. During the sintering, the temperature was raised to 1700°C at a temperature rising rate of 10°C/min and maintained at this temperature for four hours.

As a result, in the manufactured base materials 11A, 11B, which were made of silicon carbide-metal composite, the porosity of the opened pores 23 was 38%, the thermal conductivity was 130W/m·K, and the density was 2.8g/cm³. Further, the average grain diameter of the silicon carbide crystals was 10µm.

Each of the referential examples in the present embodiment has the advantages described below.
(1) In the composite that forms the table 2 in each of the referential examples, the average grain diameter of the silicon carbide crystals is 20µm to 100µm, the porosity of the porous structure is 5% to 30%, and the thermal conductivity as a whole is 160W/m·K or greater. Further, 100 parts by weight of silicon carbide is impregnated with 15 parts by weight to 45 parts by weight of the metal silicon 24.
   In addition, each of the composites include 10vol% to 50vol% of fine crystals having an average grain diameter of 0.1µm to 1.0µm and 50vol% to 90vol% of rough crystals having an average grain diameter of 25µm to 150µm.
   Thus, the value of the thermal conductivity exceeds 160W/m·K and the table 2 has very high thermal conductance. Thus, the temperature difference in the composite is smaller than the conventional products. As a result, the composite has very high thermal uniformity and thermal response. Further, the production of thermal stress is avoided and the base materials 11A, 11B resist bending. Thus, the shape stability of the composite is extremely high. Further, this enables the wafers 5 to have larger diameters and high quality.
(2) In the table 2, the cooling water W flows through the coolant passage 12, which is arranged in the bonding interface of the base materials 11A, 11B. Thus, the heat produced when grinding the semiconductor wafers 5 is directly and efficiently released from the table 2. In addition, fine control of the temperature is enabled. Thus, compared with a conventional apparatus that arranges a cooling jacket on the table to perform indirect cooling, the temperature difference in the table 2 is very small and the thermal uniformity and thermal response are improved drastically. Thus, the wafers 5 do not affect the apparatus 1 in an undesirable manner and enlargement of the diameters of the wafers 5 is possible. In addition, since the wafers 5 are ground with high accuracy, the quality of the wafers 5 is high.

The present embodiment may be modified as described below.

The impregnation metal impregnated in the sinter is not limited to the metal silicon 24, which is employed in this embodiment. Impregnation may be performed using a conductive metal material, such as aluminum, gold, silver, copper, or titanium.

### (Third Embodiment)

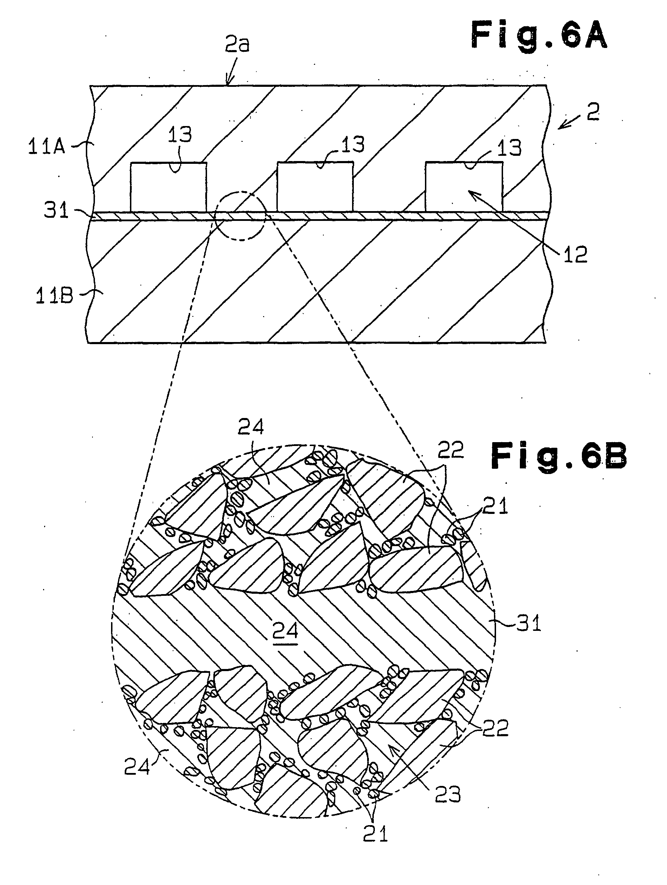

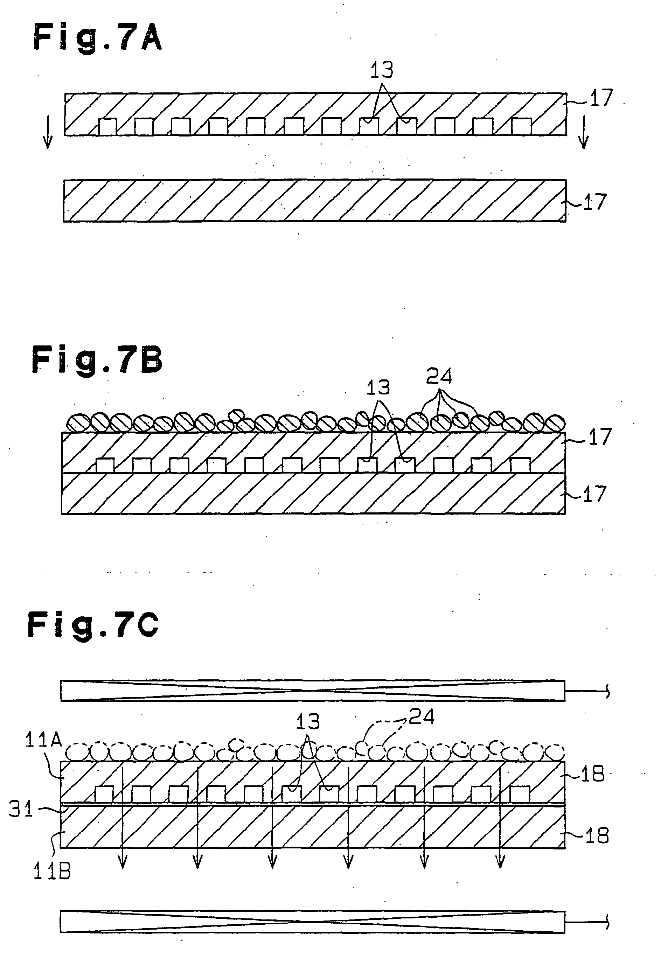

A table 2 according to a third embodiment will now be described with reference to Figs. 6 and 7. Parts that are the same as the above embodiments will not be described in detail.

In the table 2 of this embodiment, silicon carbide-metal composites 18 are adhered to each other by means of a bonding layer 31, which is made of metal silicon 24, and not the brazing material layer 14.

The difference in coefficient of thermal expansion between silicon carbide-metal composites 18 and the adhering layer 31, which is made of the metal silicon 24, is extremely small. This structure prevents the formation of cracks and exfoliation in the bonding interface. Thus, the composites 18 resists being damaged when subjected to a heat cycle and has superior long-term reliability. Further, the thermal conductivity of the metal silicon 24 is much higher than a typical adhesive. Thus, the metal silicon 24 does not increase thermal resistance in the bonding interface. Accordingly, the composites 18 have superior thermal conductivity.

It is preferred that the thickness of the bonding layer 31, which is made of metal silicon 24, be 10µm to 1500mµ, and further preferred that the thickness be 100µm to 1500mµ. This is because if the thickness of the bonding layer 31 is less than 10µm, the bonding strength may be insufficient. On the other hand, if the thickness of the bonding layer 31 is greater than 1500µm, it becomes difficult to set the conditions of impregnation such as temperature and time. This may cause the bonding to become difficult.

The reason for selecting metal silicon 24 as the impregnation metal is because metal silicon 24 easily adapts to silicon carbide and has high thermal conductivity. Thus, charging the metal silicon 24 in opened pores 23 of porous bodies 17 increases the thermal conductivity and strength. Further, unlike a resin material such as an adhesive, the coefficient of thermal expansion of the metal silicon 24 is approximate to silicon carbide. Thus, the metal silicon 24 is optimal for use as the material of the bonding layer 31.

The procedure for manufacturing the table 2 will now be discussed with reference to Fig. 3.

The silicon carbide porous body 17 is manufactured through a material preparing process, in which fine powder is mixed with rough powder at a predetermined ratio, a molding process, a sintering process, and a metal impregnating/base material bonding process. The material preparing process, the molding process, and the sintering process have already been described in detail in the above embodiments and thus will not be discussed below.

In the metal impregnating/base material bonding process that follows the sintering process, the non-impregnated porous bodies 17 are impregnated with the metal silicon 24 in the manner described below. When impregnating the metal silicon 24, it is preferred that the porous bodies 17 be impregnated with a carbonaceous substance.

First, multiple sheets of the porous bodies 17 are superimposed. Then, solid metal silicon 24 is placed on the uppermost portion of the superimposure (refer to Figs. 7A and B). In this embodiment, the solid metal silicon 24 is block-like. However, the metal silicon 24 may be powder-like, grain-like, or sheet like. Further, paste-like silicon 24 may be used in lieu of the solid metal silicon 24 and may be applied to the uppermost portion of the superimposure structure.

Then, the superimposure is set in a furnace and heated for a predetermined time at a predetermined temperature (refer to Fig. 7C). As a result, the solid or paste-like metal silicon 24 melts and falls through and out of the opened pores 23 of the porous bodies 17. This impregnates the metal silicon 24 in the porous bodies 17 and produces the desired silicon carbide-metal composites 18. Simultaneously, the bonding layer 31, which is made of metal silicon 24, bonds the composites 18 to one another.

It is preferred that the heating temperature be set at 1500°C to 2000°C. This is because if the temperature is lower than 1500°C, the metal silicon 24 does not completely melt and flow down. This may produce non-impregnation portions in the composites 18 or non-bonded portions in the bonding interface. On the other hand, if the temperature is higher than 2000°C, the metal silicon 24 vaporizes (sublimates). This may cause the amount of metal silicon 24 in the bonding interface to be insufficient and thus decrease the bonding strength. Further, since heat energy is wasted during the heating, economic efficiency and productivity may decrease.

It is preferred that the heating time be one hour or longer. This is because if the heating time is less than one hour, non-impregnated portions may be produced in the composites 18 and non-bonded portions may be produced in the bonding interface.

It is preferred that the superimposure be heated in astate in which pressure is reduced, and especially, under the condition of 5torr or less. This is because in a state in which the pressure is reduced, the air in the porous bodies 17 is easily released from the opened pores. This enables smooth impregnation of the metal silicon 24. Further, by producing an environment in which the amount of oxygen is small, oxidation of the metal silicon 24 is prevented.

A few referential examples specifically employing the present embodiment will now be discussed.

### [Referential Example 3-1]

In referential example 3-1, a rough powder (#400) of α silicon carbide having an average grain diameter of 30µm and a fine powder (GMF-15H2) of α silicon carbide having an average grain diameter of 0.3µm were prepared. Then, 30 parts by weight of the fine powder was added to 100 parts by weight of the rough powder and uniformly mixed.

Then, 5 parts by weight of polyvinyl alcohol, 3 parts by weight of phenolic resin, and 50 parts by weight of water were added to 100 parts by weight of the mixture and mixed in a ball mill for five hours to obtain a uniform mixture. After drying the mixture for a predetermined time to eliminate a certain amount of moisture, an appropriate amount of the dried mixture was granulated. In this state, the moisture rate of the granules was adjusted to about 0.8wt%. Subsequently, the granules of the mixture were molded by a metal mold by applying a pressure of 1.3t/cm². The disk-like molded product (50mmΦ, 5mmt) had a density of 2.6g/cm³.

Then, the lower surface of the molded product, which was subsequently formed into the upper base material 11A, was ground to form the grooves 13, which have a depth of 5mm and a width of 10mm, on the entire lower surface.

The molded product was then put into a graphite crucible and sintered with a Tammann sintering furnace. The sintering was performed in an argon gas atmosphere of one atmosphere. During the sintering, the temperature was raised to 2200°C at a temperature rising rate of 10°C/min and maintained at this temperature for four hours.

In the following metal impregnating/base material bonding process, the produced porous sinter was vacuum impregnated with phenolic resin (carbonization rate 30wt%) and then dried. Subsequently, two sheets of the porous bodies 17 were superimposed, and blocks of the metal silicon 24 were placed on the uppermost portion of the superimposure. The purity of the blocks of metal silicon 24 was 99.99wt% or greater. The superimposure on which the blocks of metal silicon 24 were placed was put in a furnace and heated under a reduced pressure environment of 1torr and maintained at a maximum temperature of 1800°C for about three hours. As a result, the solid metal silicon 24 was melted, and the metal silicon 24 was impregnated in the porous bodies 17. Simultaneously, the composites 18 were bonded to each other by means of the bonding layer 31. The impregnation amount of the metal silicon 24 relative to 100 parts by weight of silicon carbide was 30 parts by weight. Further, the thickness of the bonding layer 31, which was made of the metal silicon 24, was 150µm.

In the manufactured base materials 11A, 11B, which were made of the silicon carbide-metal composite, the porosity of the opened pores 23 in the porous structure was 20%, the thermal conductivity as a whole was 210W/m·K, and the density as a whole was 3.0g/cm³. Further, the average grain diameter of the silicon carbide crystals 21, 22 was 30µm. More specifically, the base materials 11A, 11B included 20vol% of the fine crystals 21 having an average grain diameter of 1.0µm and 80vol% of the rough crystals 22 having an average grain diameter of 40µm.

The coefficient of thermal expansion of the porous bodies 17 in this embodiment was 4.0×10⁻⁶/°C. The coefficient of thermal expansion of the bonding layer 31 made of metal silicon 24 was 4.2×10⁻⁶/°C and extremely approximate to that of the metal silicon 24. The thermal conductivity of the bonding layer 31, which is made of the metal silicon 24, was 150W/m·K. Thus, the bonding layer 31 was a highly thermal conductive body.

Subsequently, the surface of the upper base material 11A was ground to finally complete the table 2.

The flexural strength of the table 2 of referential example 3-1 that was produced in this manner was measured a number of times using a technique known in the art. The result indicated an average value of about 550MPa.

As schematically shown in Fig. 6B, the metal silicon 24 impregnated in the porous bodies 17 and the metal silicon 24 forming the bonding layer are continuous and have no boundaries. It is believed that this somewhat increases the flexural strength.

Further, after performing a heat cycle for a certain period of time, the table 2 was cut vertically, and the cut surface was observed by the naked eye or with a microscope. The result showed that cracks or exfoliation were not found in the bonding interface.

The table 2 of the example 3-1 that was manufactured in this manner was set on various types of the grinder 1 and the semiconductor wafers 5 of varied sizes were ground while constantly circulating the cooling water W in the coolant passage 12. The semiconductor wafers 5, which were ground by the various types of the grinder 1, were observed. There were no damages to the wafers 5 regardless of size. Further, the wafers 5 were not bent. In other words, it was confirmed that the semiconductor wafers 5 having large diameters and high quality were manufactured when using the table 2 of referential example 3-1.

### [Referential Example 3-2]

In referential example 3-2, the table 2 was manufactured with the bonding layer 31 having a thickness of 50µm. The other conditions were basically the same as those of referential example 3-1.

The flexural strength of the produced table 2 was measured a number of times, and the average value was about 550MPa. Further, after performing a heat cycle for a certain period of time, the cut surface of the table 2 was observed. The result showed that cracks or exfoliation were not found at all in the bonding interface.

The table 2 was set on various types of the grinder 1 and the semiconductor wafers 5 of varied sizes were ground. Excellent results similar to those of referential example 3-1 were obtained. That is, there were no damages to or bending of the wafers 5, and it was confirmed that the semiconductor wafers 5 having large diameters and high quality were manufactured.

### [Referential Example 3-3]

In referential example 3-3, the table 2 was manufactured with the bonding layer 31 having a thickness of 1500µm. The other conditions were basically the same as those of referential example 3-1.

The flexural strength of the produced table 2 was measured a number of times, and the average value was about 550MPa. Further, after performing a heat cycle for a certain period of time, the cut surface of the table 2 was observed. The result showed that cracks or exfoliation were not found at all in the bonding interface.

The table 2 was set on various types of the grinder 1 and the semiconductor wafers 5 of varied sizes were ground. Excellent results similar to those of referential example 3-1 were obtained. That is, there were no damages to or bending of the wafers 5, and it was confirmed that the semiconductor wafers 5 having large diameters and high quality were manufactured.

### [Comparative Example 3-1]

In comparative example 3, the base substrates 11A, 11B were manufactured by impregnating each porous body 17 with the metal silicon 24. Then, a brazing material made of Ag-Cu-Ti was used to braze and bond the base materials 11A, 11B to each other. The other conditions were basically the same as referential example 3-1 when producing the table 2. The thermal conductivity of the brazing material was 170W/m·K and slightly higher than the metal silicon 24. The coefficient of thermal expansion of the brazing material was 18.5×10⁻⁶/°C and somewhat greater than the metal silicon 24.

In comparative example 3-1, the impregnation of the metal silicon 24 and the bonding of the base materials 11A, 11B were performed in different processes. Thus, comparative example 3-1 was inferior to the three referential examples from the viewpoint of productivity and cost.

Then, the flexural strength of the produced table 2 was measured a number of times, and the average value was about 400MPa, which is a value lower than the three referential examples. Further, after performing a heat cycle for a certain period of time, the cut surface of the table 2 was observed. The result showed that cracks or exfoliation were found in the bonding interface.

### [Comparative Example 3-2]

In referential example 3-2, the base substrates 11A, 11B were manufactured by impregnating each porous body 17 with the metal silicon 24. Then, a resin adhesive (manufactured by Cemedine) was used to adhere the base materials 11A, 11B to each other. The other conditions were basically the same as referential example 3-1 when producing the table 2. The thermal conductivity of the adhesive was 0.162W/m·K and much lower than the metal silicon 24. The coefficient of thermal expansion of the adhesive was 65×10⁻⁶/°C and much greater than the metal silicon 24.

In comparative example 3-2, the impregnation of the metal silicon 24 and the bonding of the base materials 11A, 11B were performed in different processes. Thus, comparative example 3-2 was inferior to the three referential examples from the viewpoints of productivity and cost.

Then, the flexural strength of the produced table 2 was measured a number of times, and the average value was about 50MPa, which is a value further lower than comparative example 3-1. Further, after performing a heat cycle for a certain period of time, the cut surface of the table 2 was observed. The result showed that cracks or exfoliation were found in the bonding interface.

Each of the referential examples in this embodiment has the advantages described below.
(1) In the table 2 of each referential example, two sheets of the silicon carbide-metal composite 18 are bonded to each other by the bonding layer 31, which is made of the metal silicon 24. The difference between the coefficient of thermal expansion of the bonding layer 31 and the coefficient of thermal expansion of the composites 18 (which is substantially the same as the coefficient of thermal expansion of silicon carbide) is about 0.2×16⁻⁶/°C and extremely small. Thus, thermal stress is not produced by the coefficient of thermal expansion difference and the formation of cracks and exfoliation is prevented. Thus, the table 2 resists being damaged when subjected to a heat cycle and has superior long-term reliability. Further, the thermal conductivity of the metal silicon 24 is much higher than an adhesive. Thus, the metal silicon 24 does not increase thermal resistance in the bonding interface. Accordingly, the table 2 has superior thermal conductivity.
(2) In the referential examples, when manufacturing the table 2, the impregnation of the metal silicon 24 and the bonding of the composites 18 are performed simultaneously. Accordingly, in comparison to when performing each process separately, the table 2 is efficiently produced. This ensures that the optimal table 2 is produced inexpensively.
(3) In the referential examples, the formation of cracks and exfoliation in the bonding interface is prevented, and damages do not occur when a heat cycle is performed. This prevents water from leaking from the coolant passage 12, and the table 2 has long-term reliability. Further, the bonding layer 31, which is made of the metal silicon 24, does not increase thermal resistance in the bonding interface. Thus, the table has superior thermal conductivity. Accordingly, the temperature difference in the table 2 is low, and the table 2 has extremely high thermal uniformity and thermal response. Therefore, a large diameter, high quality wafer 5 is manufactured by using the table 2 in the wafer grinder 1.

This embodiment may be modified as described below.

The porous body 17, which is made of a silicon-containing ceramic, may be made of a material other than silicon carbide, such as silicon nitride, to produce the table 2. Further, instead of employing composites 18 formed from the same type of ceramic, the composites 18 may be formed from different types of ceramics (e.g., a combination of silicon carbide and silicon nitride).

The present invention is not to be limited to the first to third embodiments. Further, the present invention is not to be limited to the details given herein, but may be modified within the scope of the appended claims.

## Claims

1. A porous silicon carbide sinter having a structure formed by silicon carbide crystals (21, 22) that includes opened pores (23), wherein the porous sinter has a silicon carbide crystal average grain diameter of 20µm or greater, a porosity of 40% or less, and a thermal conductivity of 80W/m·K or more.

2. A porous silicon carbide sinter having a structure formed by silicon carbide crystals (21, 22) that includes opened pores (23), wherein the porous sinter has a silicon carbide crystal average grain diameter of 20µm to 100µm, a porosity of 5% to 30%, and a thermal conductivity of 80W/m·K or more.

3. The porous silicon carbide sinter according to claim 1 or 2, **characterized in that** the silicon carbide crystals include 10vol% to 50vol% of fine silicon carbide crystals (21) having an average grain diameter of 0.1µm to 1.0µm and 50vol% to 90vol% of rough silicon carbide crystals (22) having an average grain diameter of 25µm to 150µm.

4. A method for manufacturing a porous silicon carbide sinter having a structure formed by silicon carbide crystals (21, 22) that includes opened pores (23), wherein the porous silicon carbide sinter has a silicon carbide crystal average grain diameter of 20µm or greater, a porosity of 30% or less, and a thermal conductivity of 80W/m·K or more, the method comprising the steps of:
adding 10 parts by weight to 100 parts by weight of a fine powder of α silicon carbide having an average grain diameter of 0.1µm to 1.0µm to 100 parts by weight of a rough powder of α silicon carbide having an average grain diameter of 5µm to 100µm and uniformly mixing the rough powder and the fine powder;
molding a mixture obtained in the mixing step into a predetermined shape to produce a molded product; and
sintering the molded product within a temperature range of 1700°C to 2400°C to produce a sinter.

5. A member (2) used in a wafer grinder, wherein the wafer grinder member is formed from the porous silicon carbide sinter according to any one of claims 1 to 3.

6. A wafer grinder table having a grinding surface (2a) for grinding a semiconductor wafer held on a wafer holding plate, the table including:
a plurality of bonded base materials (11A, 11B), each formed from the porous silicon carbide sinter according to any one of claims 1 to 3; and
a fluid passage (12) formed in a bonding interface of the base materials.

7. A silicon carbide-metal composite having a porous structure formed by silicon carbide crystals (21, 22) that includes opened pores (23), wherein the opened pores are impregnated with metal, wherein the silicon carbide-metal composite has a silicon carbide crystal average grain diameter of 20µm or greater, a porosity of 30% or less, and a thermal conductivity of 160W/m·K or more, and wherein 100 parts by weight of silicon carbide are impregnated with 15 parts by weight to 50 parts by weight of metal.

8. A silicon carbide-metal composite having a porous structure formed by silicon carbide crystals (21; 22) that includes opened pores (23), wherein the opened pores are impregnated with metal, wherein the silicon carbide-metal composite has a silicon carbide crystal average grain. diameter of 20µm to 100µm, a porosity of 5% to 30%, and a thermal conductivity of 160W/m·K or more, and wherein 100 parts by weight of silicon carbide are impregnated with 15 parts by weight to 50 parts by weight of metal.

9. The silicon carbide-metal composite according to claim 7 or 8, **characterized in that** 100 parts by weight of silicon carbide is impregnated with 15 parts by weight to 45 parts by weight of metal silicon.

10. The silicon carbide-metal composite according to claim 7 or 8, **characterized in that** 100 parts by weight of silicon carbide is impregnated with 20 parts by weight to 50 parts by weight of metal aluminum.

11. The silicon carbide-metal composite according to any one of claims 7 to 10, **characterized in that** the silicon carbide crystals include 10vol% to 50vol% of fine silicon carbide crystals (21) having an average grain diameter of 0.1µm to 1.0µm and 50vol% to 90vol% of rough silicon carbide crystals (22) having an average grain diameter of 25µm to 150µm.

12. A method for manufacturing a silicon carbide-metal composite having a porous structure formed by silicon carbide crystals (21, 22) that includes opened pores (23), wherein 100 parts by weight of silicon carbide is impregnated with 15 parts by weight to 50 parts by weight of metal in the opened pores, the average grain diameter of the silicon carbide crystals is 20µm or greater, the porosity is 30% or less, and the thermal conductivity is 160W/m·K or greater, the method comprising the steps of:
adding 10 parts by weight to 100 parts by weight of a fine powder of α silicon carbide having an average grain diameter of 0.1µm to 1.0µm to 100 parts by weight of a rough powder of α silicon carbide having an average grain diameter of 5µm to 100µm and uniformly mixing the rough powder and the fine powder;
molding a mixture produced in the mixing step into a predetermined shape to produce a molded product;
sintering the molded product within a temperature range of 1700°C to 2400°C to produce a sinter; and
impregnating the molded product or the sinter with metal.

13. The method for manufacturing a silicon carbide-metal composite according to claim 12, **characterized in that** 1wt% to 10wt%, in carbon weight converted value, of an organic substance serving as a carbide source is added to the molded product.

14. A member (2) used in a wafer grinder, wherein the wafer grinder member is formed from the silicon carbide-metal composite according to any one of claims 7 to 11.

15. A wafer grinder table having a grinding surface (2a) for grinding a semiconductor wafer held on a wafer holding plate, the table (2) including:
a plurality of bonded base materials (11A, 11B), each formed from the silicon carbide-metal composite according to any one of claims 7 to 11; and
a fluid passage formed in a bonding interface of the base materials.

16. A wafer grinder table having a grinding surface (2a) for grinding a semiconductor wafer held on a wafer holding plate, the table (2) including:
a plurality of base materials (11A, 11B), each of which is a ceramic-metal composite formed by impregnating metal silicon in opened bores of a porous body made of silicon-containing ceramic;
a bonding layer (14) formed from the metal silicon to bond the base materials; and
a fluid passage (12) formed in a bonding interface of the base materials.

17. The wafer grinder table according to claim 16, **characterized in that**, in the ceramic-metal composite, the porous body includes silicon carbide crystals with an average grain diameter of 20µm to 100µm, has a porosity of 10% to 50%, and has a thermal conductivity of 160W/m·K or more, and wherein 100 parts by weight of silicon carbide is impregnated with 15 parts by weight to 50 parts by weight of the metal silicon.

18. The wafer grinder table according to claim 17, **characterized in that** the silicon carbide crystals include 10vol% to 50vol% of fine silicon carbide crystals (21) having an average grain diameter of 0.1µm to 1.0µm and 50vol% to 90vol% of rough silicon carbide crystals (22) having an average grain diameter of 25µm to 150µm.

19. The wafer grinder table according to any one of claims 15 to 18, **characterized in that** the bonding layer has a thickness of 10µm to 1500µm.
